# EUROPÄISCHE PATENTSCHRIFT

(11) **EP 3 285 403 B1**
(45) Veröffentlichungstag und Bekanntmachung des Hinweises auf die Patenterteilung: **09.01.2019**
(21) Anmeldenummer: 17001357.7
(22) Anmeldetag: 08.08.2017
(51) Int. Cl.: H04B 1/04, H04B 1/18, G01D 4/00, H03H 7/40

(54) **VERFAHREN UND EINRICHTUNG ZUM VERBESSERN DER ANTENNENANPASSUNG BEI EINEM SMARTMETER-ZÄHLER**
METHOD AND DEVICE FOR IMPROVING THE ANTENNA ADJUSTMENT OF A SMART METER
PROCÉDÉ ET DISPOSITIF PERMETTANT D'AMÉLIORER L'ADAPTATION D'IMPÉDANCE D'ANTENNE D'UN COMPTEUR ÉLECTRIQUE INTELLIGENT

(30) Priorität: 18.08.2016 DE 102016010045
(43) Veröffentlichungstag der Anmeldung: 21.02.2018
(73) Patentinhaber: Diehl Metering S.A.S., 68300 Saint-Louis (FR); Diehl Metering Systems GmbH, 90451 Nürnberg (DE)
(72) Erfinder: Bach, Guy, FR - 68640 Waldighoffen (FR); Kauppert, Thomas, DE - 90455 Nürnberg (DE); Sonnenberger, Michael, DE - 80687 München (DE); Mzyk, Raphael, DE-91126 Kammerstein (DE)
(74) Vertreter: Diehl Patentabteilung

(56) Entgegenhaltungen:
- WO-A1-2016/021105
- JP-A- 2011 082 592
- US-A1- 2015 180 593

## Beschreibung

Beim Smartmetering wird angestrebt, jede Verbrauchsstelle für leitungsgebundene Energieträger wie Strom, Gas, Wasser oder Fernwärme mit einem Messwerk und mit einem Zähler für dessen verbrauchsabhängig generierten Signale auszustatten. In der EP 2 953 275 A1 ist beschrieben, wie eine Aufeinanderfolge von Zählerständen jeweils digitalisiert und als Paket vom Sendemodul des Zählers per Datenfunk über eines der lizenzfrei verfügbaren Nahbereichs-Frequenzbänder an einen abgesetzt betriebenen Konzentrator übermittelt wird. Im Konzentrator werden die, hinsichtlich ihrer Herkunft individualisierten, aktuellen Zählerstände von mehreren in seinem Empfangsbereich betriebenen derartigen Zählern zwischengespeichert und später bedarfsweise im Mobilfunk-Standard an eine Zentrale etwa zu Verbrauchsabrechnungen übermittelt.

Die Funkverbindungen arbeiten bidirektional. Dadurch ist es insbesondere möglich, beim Zähler etwa ferngesteuert Tarifänderungen vorzunehmen oder bedarfsweise durch gezielten vorübergehenden Lastabwurf das Versorgungsnetz zu stabilisieren.

Die schaltungstechnische Auslegung der Empfänger- und Sendermodule beim Konzentrator, sowie dessen Ausstattung mit einer vergleichsweise großflächigen, auf Resonanz abgestimmten schmalbandigen Antenne, ist unkritisch, da hier regelmäßig genügend Raum und auch elektrische Betriebsenergie aus Batterien oder gar einem Netzanschluss verfügbar sind.

Aber das Messwerk zum verbrauchsabhängigen Ansteuern des Zählers und dessen Funkmodul sollen möglichst kleinbauend sein. Da ein Netzanschluss hier regelmäßig nicht verfügbar ist, muss bei jedem Zähler autark mit Batterien gearbeitet werden, von denen eine störungs- und wartungsfreie Betriebszeitspanne von über zehn bis zu zwanzig Jahren erwartet wird. Deshalb muss die Funkkommunikation hier mit möglichst geringem energetischem Aufwand zuverlässig betrieben werden können. Das setzt im Funkmodul eine hohe Empfindlichkeit infolge guter Anpassung der Schaltung an die schmalbandig dimensionierte Antenne (Anpassung auf Resonanz) voraus.

In dem Zusammenhang ist aus der DE 10 2013 012 041 B4 beim Smartmetering das Problem bekannt, dass sich in den kleinbauenden Gehäusen zur Aufnahme des Messwerkes samt des Zählers mit seinem Funkmodul nur verkürzte Antennen (insbesondere Planarantennen, aber etwa auch Helixantennen) unterbringen lassen. Der aus unvollständiger Antennengeometrie resultierende Stromfluss muss dann von einer Antennen-Gegenmasse aufgenommen werden. Deren optimierte Bemessung und Anordnung wird aber schon wieder obsolet, wenn die Antennenimpedanz dann am Betriebsort beeinflusst wird. Denn alle Massen, die das elektromagnetische Nahfeld durchsetzen, haben Einfluss auf die Antennenimpedanz, insbesondere natürlich ferromagnetische Metalle. Das tritt etwa ein, wenn das dem Funkmodul benachbarte Messwerk an ein Rohr für die Zufuhr des Energieträgers angeschlossen wird; oder auch bereits dann, wenn nach Abschluss der im Schaltschrank durchgeführten Installations- und Abgleicharbeiten dessen Tür geschlossen wird. Dadurch ändert sich die Resonanzfrequenz, und die Energieabstrahlung ist wegen der nun wieder fehlangepassten schmalbandigen Antenne nicht mehr optimal, die Sendereichweite deshalb eingeschränkt, und die Störanfälligkeit der an den Konzentrator zu übermittelnden Zählerstands-Datenpakete vergrößert sich.

Das gilt grundsätzlich auch für beim Zähler vom Konzentrator zu empfangende Informationen. Da jedoch beim Konzentrator genügend Ressourcen für ein kräftiges Sendesignal verfügbar sind, zeigt in erster Linie der Sendebetrieb des Zählers eine kritische Abhängigkeit von Resonanzverschiebungen infolge von externen variablen Feldbeeinflussungen während des Smartmetering-Betriebes.

Zum Verbessern einer Antennenanpassung sind nach der JP 2011 082592 A ein Sender für ein Testsignal und ein Testsignal-Empfänger, mit einstellbarer Antennenanpassung zu Maximieren des Testsignal-Empfangspegels, vorgesehen. Mit der erreichten Antennenanpassung wird das Senden des Testsignales wiederholt, um so die Antennenanpassung iterativ zu optimieren. Nach der US 2015/0180593 A1 ist zur Nahfeld-Antennenanpassung ein Netzwerk aus rein induktiven Impedanzen vorgesehen.

Die gattungsbildende WO 2016/021105 A1 (entsprechend der nachveröffentlichten EP 3 179 635 A1) hat zum Gegenstand, der Abhängigkeit der Qualität der Funkübertragung von Zählern an Konzentratoren von Änderungen feldbeeinflussender Umgebungsgegebenheiten möglichst entgegenzuwirken. Dazu ist der Zähler mit einem RSSI-Detektor für insbesondere vom Konzentrator empfangene Signale ausgestattet. Auf Empfangspegeleinbrüche wird durch Neuauslegung der Antennenanpassung im Zähler reagiert. Die dafür im Zähler erforderlichen Berechnungen sind allerdings apparativ sehr aufwändig und zeitintensiv. Deshalb lässt sich eine die Datenauswertung störende zeitliche Kollision mit der Pegelkompensation im Zähler nicht vermeiden, obgleich in Betracht gezogen wird, dafür in den Empfangssignalen Zeitpuffer vorzuhalten.

Demgegenüber liegt vorliegender Erfindung die Aufgabe zugrunde, den schaltungs- und datenverarbeitungstechnischen Aufwand zu Aktualisieren der Antennenanpassung bei Smartmeter-Zählern weiter zu reduzieren.

Diese Aufgabe ist erfindungsgemäß durch die in den unabhängigen Ansprüchen jeweils angegebenen wesentlichen Merkmale gelöst.

Demzufolge werden, nach Aufnahme regulären Betriebs des Smartmeter-Funknetzwerkes aus mehreren Zählern und wenigstens einem Konzentrator, von Zeit zu Zeit immer wieder einmal von den Zählern nacheinander herkunftscodierte Test-Pakete bei definierter Sendefrequenz mit unterschiedlichen Einstellungen bezüglich der Abstimmung zur Antennenanpassung ausgesendet. In wenigstens einem der Konzentratoren werden solche Pakete empfangen; die Empfangsfeldstärken der Pakete werden dort ausgewertet. Der Zähler sendet fortan seine Nutz-Pakete mit derjenigen der Antennenanpassungen, die zu wenigstens brauchbarem Empfang der Test-Pakete beim Konzentrator geführt hatte. Da dieselbe Antenne des Zähler-Funkmodules bidirektional benutzt wird, bleibt die aktuell optimierte Antennenanpassung auch für Empfang vom Konzentrator wirksam.

Zwischenzeitlich geänderten umgebungsbedingten Auswirkungen auf die Antennenanpassung des Funkmodules wird so von Zeit zu Zeit durch selbsttätiges Kompensieren einer Fehlanpassung der Antenne entgegengewirkt, um die Resonanzfrequenz für die gegebene Antenne möglichst konstant zu halten.

Für solches gelegentliches Nachjustieren der Antennenanpassung durch Resonanzabstimmung könnten die ohnehin vom Konzentrator empfangenen Datenpakete herangezogen werden, die dann dazu vorübergehend bei aufeinanderfolgend unterschiedlichen Resonanzverstimmungen gesendet werden. Zweckmäßiger jedoch ist es, eine raschere Aufeinanderfolge standardisierter Test-Pakete mit den definiert unterschiedlichen Resonanzvorgaben auszusenden, weil das die RSSI-Pegelmessung fördert und so einen etwaigen Korrekturbedarf für die Messdatenübermittlung leichter ermitteln lässt, als ein Verwenden von Nutzdaten-Paketen.

Das Variieren des Resonanzabgleiches von Testpaket zu Testpaket erfolgt vorteilhafter Weise voneinander unabhängig bei allen Zählern in wenigen übereinstimmend vorgegebenen Abstufungen von Antennenanpassungen, etwa durch ein zyklisches Umschalten längs einer abgestuften Folge von Resonanz-Induktivitäten oder -Kapazitäten für die Antennenabstimmung im Funkmodul des jeweiligen Zählers.

Zum Erfassen der dem jeweiligen Zähler zuzuordnenden Empfangsfeldstärken genügt es, hinter der Empfangsschaltung des Konzentrator-Funkmodules eine RSSI-Schaltung zu betreiben, wie sie oft schon standardmäßig in kommerzielle Funkmodule integriert ist.

Die Auswertung der aufeinanderfolgenden Empfangsfeldstärken kann prinzipiell - nach Rückmeldung des Empfangssignales vom Konzentrator - beim Zähler vorgenommen werden. Dann geht allerdings die aktuelle (Fehl-)Anpassung der Antenne im Funkmodul des Konzentrators mit in die Beurteilung ein. Und die doppelte Übertragung über das Nahbereichs-Frequenzband, vom Zähler zum Konzentrator und von dem zurück zum Zähler, vergrößert die Einflüsse von Übertragungsstörungen. Vor allem aber sollten die nur beschränkt im Zähler verfügbaren Ressourcen nicht zusätzlich durch eine Feldstärken-Auswertung belastet werden. Deshalb ist der Beurteilung der aktuellen Antennenanpassung beim Empfang der Pakete im Konzentrator der Vorzug einzuräumen.

Bei der hier so genannten Ping-Pong-Testbetriebsversion sendet das bidirektional arbeitende Funkmodul des Zählers mit seiner aktuell gegebenen Antennenanpassung über ein Nahbereichs-Frequenzband ein (Test-)Paket aus, das von wenigstens einem Konzentrator im Smartmeter-Funknetz empfangen wird. Der RSSI-Detektor hinter der Empfangsschaltung im Konzentrator-Funkmodul quantisiert die Empfangsfeldstärke, und diese Information kann vom Konzentrator über das Nahbereichs-Frequenzband an den Zähler zurück übermittelt werden. Der Empfang im Zähler löst das Senden des Test-Paketes bei der nächstfolgenden der abgestuft vorgegebenen Antennenabstimmungen aus.

Wenn eine Empfangsfeldstärke beim Konzentrator eine als hinreichend vorgegebene Schwelle erreicht oder überschreitet, wird der Testbetrieb gestoppt, und fortan erfolgt das Senden der Nutzdaten-Pakete mit dieser Resonanzeinstellung als momentan guter, jedenfalls brauchbarer Antennenanpassung.

Der Wiederholzyklus für das automatische Aussenden der Testpakete bei aufeinanderfolgend unterschiedlichen Resonanzbedingungen wird, je nach den Belangen der Praxis, zweckmäßigerweise auf vier- bis achtmal pro Kalenderquartal vorgegeben; je nachdem, wie stark mit wechselnden Feldbeeinflussungen in der näheren Umgebung des Zählers mit seinem Sender zu rechnen ist (deshalb etwa in industrieller Fertigungsumgebung häufiger, als im Installations-Anschlussraum eines Wohngebäudes).

Jedoch startet der erste derartige Testzyklus vorzugsweise schon bald (wenige Stunden) nach Abschluss der Installationsarbeiten zur Inbetriebnahme des Smartmeter-Funknetzes. Denn in der Praxis ist nicht auszuschließen, dass sich zu jenem Zeitpunkt etwa noch ein Werkzeugkasten neben dem Schaltschrank beziehungsweise ein Werkzeug oder Verpackungsreste auf dem Schaltschrank des Zählers befunden hatten, die dann erst, nach Abschluss der Inbetriebnahme des Smartmeter-Funknetzes, fortgeräumt wurden - mit der Folge, dass die soeben installierte Antennenanpassung wegen anschließend veränderter Feldbeeinflussung gleich schon wieder eine Fehlanpassung ist.

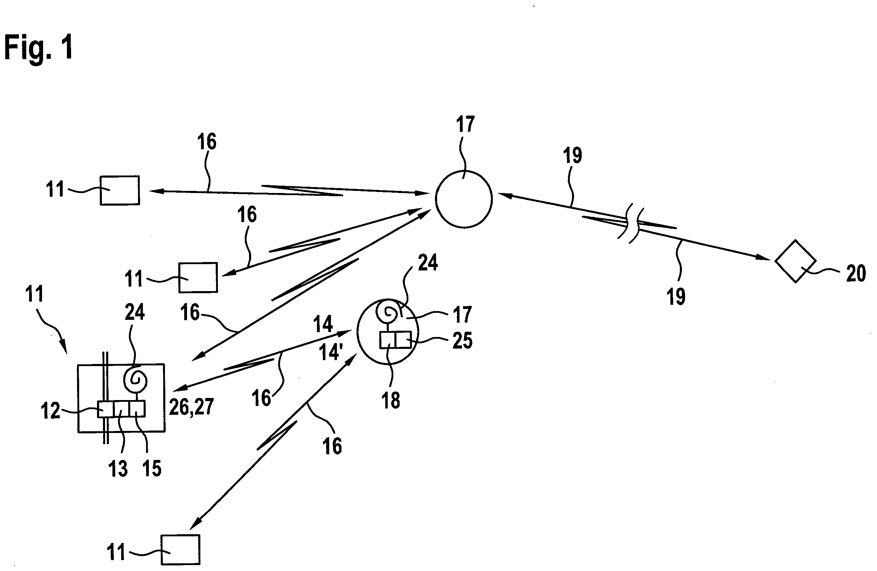

Zusätzliche Weiterbildungen und Abwandlungen zur erfindungsgemäßen Lösung ergeben sich aus den weiteren Ansprüchen und, auch unter Berücksichtigung von deren Vorteilen, aus nachstehender Beschreibung eines stark vereinfacht auf das Funktionswesentliche abstrahierten Realisierungsbeispieles zur Erfindung. Die Zeichnungsskizze zeigt in
- Fig.1: ein Smartmeter-Funknetz mit vielen Zählern, wenigen Konzentratoren und einer Zentrale sowie
- Fig.2: eine Induktivitätenbank beim Zähler-Funkmodul nach Fig.1, für dessen zyklisch variierende Antennenanpassung.

Eine Anzahl von Energie-Verbrauchsstellen 11 ist jeweils mit einem Messwerk 12 ausgestattet, das verbrauchsabhängig Impulse an einen Zähler 13 liefert. Die darin akkumulierte Verbrauchsinformation wird digitalisiert und sporadisch als Paket 14 über einen bidirektionalen Funkmodul 15 in einem der öffentlich zugänglichen ISM-Nahbereichs-frequenzbänder 16 abgestrahlt.

Wenigstens einer der im Empfangsbereich installierten Konzentratoren 17 empfängt mit seinem Funkmodul 18 das Paket 14 zur Zwischenspeicherung und gegebenenfalls Telegrammaufbereitung; bis es aus den Konzentratoren 17 über Weitbereichs-Mobilfunkverbindungen 19 von dem Server einer Betriebs-Zentrale 20, etwa zum Erstellen einer Verbrauchsabrechnung, übernommen wird.

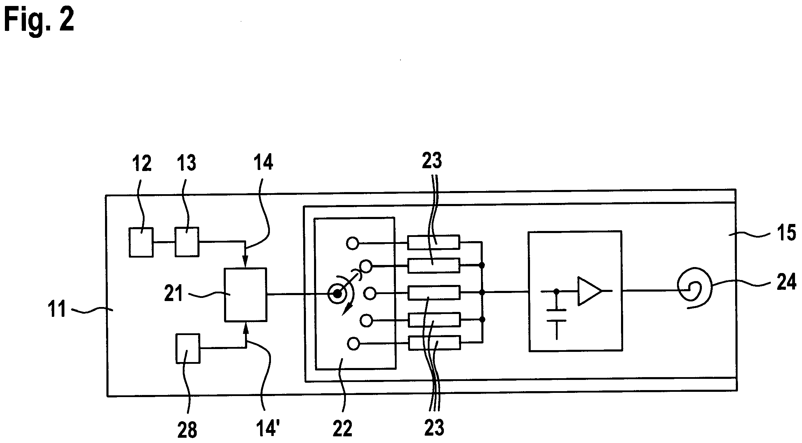

Von Zeit zu Zeit sendet der Zähler 13 eine Gruppe von Test-Paketen 14' mit der Reihe nach definiert abgestuft verstimmten Antennenanpassungen. Gemäß Fig.2 sind die Test-Pakete 14' dafür in der Verbrauchsstelle 11 hinterlegt, und deren Abfolge wird von einer Zeitschaltung 21 ausgelöst. Unter Beibehalten der Sendefrequenz ändert ein Umschalter 22 von einem Test-Paket 14' zum nächstfolgenden die Anpassung der Sende- und Empfangs-Antenne 24 des Zählers 13, hier veranschaulicht durch aufeinanderfolgend definiert unterschiedliche Induktivitäten 23 (allgemein: komplexe Widerstände). Deren unterschiedlichen Fehlanpassungen führen zu unterschiedlichen Antennenleistungen und dementsprechend zu unterschiedlichen Empfangsfeldstärken beim Konzentrator 17. Beim bidirektionalen Funkmodul 18 des Konzentrators 17 ist dem Empfänger ein RSSI-Detektor 25 zum Ermitteln der aufeinanderfolgenden Empfangsfeldstärken nachgeschaltet.

Einen geringeren Aufwand für die Antennenanpassung, als eine Maximumsuche unter abgespeicherten Absolutwerten der Empfangsfeldstärken zu der Folge der Test-Pakete 14', bedingt eine nur relative Empfangsauswertung in dem Sinne, dass ein bloßer, ausreichenden Empfang repräsentierender Schwellwert für die Empfangsfeldstärke im Konzentrator 17 hard- oder softwaremäßig vorgegeben wird. Nach dem Ping-Pong-Prinzip löst der Empfang eines Test-Paketes 14' beim Konzentrator 17 über Funk im Zähler 13 das Senden des nächsten Test-Paketes 14', bei geänderter Resonanzbedingung, aus. Sobald aber eine Empfangsfeldstärke jenen vorgegebenen Schwellwert übersteigt, liefert der RSSI-Detektor 25 einen Stopp-Befehl 27 an den Zähler 13; das Aussenden weiterer Test-Pakete 14' wird unterbunden, und das Zähler-Funkmodul 15 wird künftig für die Übermittlung der Nutz-Datenpakete 14 bei dieser gerade erreichten Antennenanpassung betrieben.

Um also in einem Smartmetering-Funknetz Verstimmungen der Antennenanpassung im Funkmodul 15 beim Zähler 13 entgegenzuwirken, die von wechselnden Einflüssen auf das elektromagnetische Nahfeld der Antenne herrühren, wird erfindungsgemäß von Zeit zu Zeit mit vorgegebener Sendefrequenz eine Folge von Test-Paketen 14' bei unterschiedlichen Antennenresonanzanpassungen gesendet; wofür längs einer Bank von abgestuften komplexen Resonanzwiderständen umgeschaltet wird. Es könnte vorgesehen sein, die Empfangssignale oder deren quantisierten Empfangsfeldstärken empfangener Pakete 14/14' vom Konzentrator 17 an das Funkmodul 15 des Zählers 13 zurückzusenden, um die Auswertung für die künftig zu nutzende Antennenabstimmung dort durchzuführen. Zu bevorzugen ist aber, diese Auswertung im Konzentrator 17 durchzuführen, also hierzu den empfangenen Paketen 14' deren Empfangsfeldstärken festzustellen. Bei Erscheinen ausreichender Empfangsfeldstärke kann ein aktueller Test-Zyklus mittels eines an den Zähler 13 gesendeten Stopp-Befehles 27 beendet werden, um die Nutz-Pakete 14 künftig mit der aktuellen Antennenanpassung gemäß der gerade eingestellten Induktivität 23 und / oder Kapazität zu übertragen. Solche RSSI-Rückmeldung vom empfangenden Funkmodul 18 an den Zähler 13 führt so immer wieder zu optimalen Betriebsbedingungen für die Antenne 24, ohne an ihr eigens Leistungsmessungen zum Bestimmen und Korrigieren einer Antennen-Fehlanpassung vornehmen zu müssen.

### Bezugszeichenliste

- 11: Verbrauchsstelle
- 12: Messwerk
- 13: Zähler
- 14: Paket; 14' Test-Pakete
- 15: Funkmodul
- 16: Nahbereichsfrequenzband
- 17: Konzentrator
- 18: Funkmodul
- 19: Mobilfunkverbindung
- 20: Zentrale
- 21: Zeitschaltung
- 22: Umschalter
- 23: Induktivität
- 24: Antenne
- 25: RSSI-Detektor
- 26: Betriebsvorgabe
- 27: Stopp-Befehl

## Patentansprüche

1. Verfahren zum Verbessern der Antennenanpassung in einem Smartmeter-Zähler (13) bei bidirektionalen Nahbereichs-Funkverbindungen zwischen einem Zähler-Funkmodul (15) des Smartmeter-Zählers (13) und wenigstens einem Konzentrator-Funkmodul (18) eines Konzentrators (17), wobei von Zeit zu Zeit vom Zähler-Funkmodul (15) mit vorgegebener Sendefrequenz nacheinander eine Reihe von Test-Paketen (14') bei jeweils unterschiedlichen, vorgegebenen Antennenanpassungen gesendet wird und dieses Senden von Test-Paketen (14') gestoppt wird, wenn dem Smartmeter-Zähler (13) vom empfangenden Konzentrator-Funkmodul (18) eine hinreichend hohe Empfangsfeldstärke signalisiert wird, woraufhin künftig Nutzdaten-Pakete (14) bei der aktuell eingestellten der vorgegebenen Antennenanpassungen gesendet werden.

2. Verfahren nach Anspruch 1, **dadurch gekennzeichnet, dass** vom empfangenden Konzentrator-Funkmodul (18) ein Hinweis auf eine momentan ausreichende Empfangsfeldstärke an das Zähler-Funkmodul (15) übermittelt wird.

3. Verfahren nach Anspruch 1 oder 2, **dadurch gekennzeichnet, dass** nach Stoppen des Sendens der Test-Pakete (14') das Senden der Nutzdaten-Pakete (14) künftig mit aktuell eingestellten Antennenanpassung erfolgt, die am empfangenden Konzentrator-Funkmodul (18) gerade die hinreichend hohe Empfangsfeldstärke erbringt.

4. Verfahren nach einem der vorangehenden Ansprüche, **dadurch gekennzeichnet, dass** in einem Ping-Pong-Betrieb von einer Rückmeldung des empfangenden Konzentrator-Funkmodules (18) das Senden mit der nächsten aus der Folge von unterschiedlichen, vorgegebenen Antennenanpassungen beim Zähler-Funkmodul (15) ausgelöst wird.

5. Verfahren nach einem der vorangehenden Ansprüche, **dadurch gekennzeichnet, dass** die Test-Pakete (14') und die Nutzdaten-Pakete (14) mit der aktuellen Antennenanpassung gemäß der gerade eingestellten Resonanz-Induktivität (23) oder -Kapazität gesendet werden.

6. Verfahren nach einem der vorangehenden Ansprüche, **dadurch gekennzeichnet, dass** es zeitgesteuert oder periodisch wiederholt durchgeführt wird, dass es aber erstmals schon kurzfristig nach Betriebsbeginn eingeleitet wird.

7. Einrichtung zum Verbessern einer Antennenanpassung in einem Smartmeter-Zähler (13), der mit einem bidirektionalen Zähler-Funkmodul (15) für eine bidirektionale Nahbereichs-Funkverbindung zu wenigstens einem Konzentrator-Funkmodul (18) eines Konzentrators (17) ausgestattet ist, wobei das Zähler-Funkmodul (15) dazu eingerichtet ist, von Zeit zu Zeit nacheinander eine Reihe von Test-Paketen (14') auszusenden und dabei zum Einstellen unterschiedlicher, vorgegebener Antennenanpassungen zwischen unterschiedlichen Resonanz-Induktivitäten (23) oder -Kapazitäten umzuschalten, bis vom Konzentrator (17) ein Erreichen einer hinreichend hohen Empfangsfeldstärke an den Smartmeter-Zähler (13) rückgemeldet wird, um fortan Nutzdaten-Pakete (14) mit der aktuell eingestellten der vorgegebenen Antennenanpassungen zu senden.

8. Einrichtung nach dem vorangehenden Anspruch, **dadurch gekennzeichnet, dass** ein RSSI-Detektor (25) beim empfangenden Konzentrator-Funkmodul (18) vorgesehen ist.

## Claims

1. Method for improving the antenna matching in a smart meter (13) in the case of bidirectional close-range radio connections between a meter radio module (15) of the smart meter (13) and at least one concentrator radio module (18) of a concentrator (17), wherein the meter radio module (15) from time to time transmits a number of test packets (14') in succession at a predefined transmission frequency with respectively different predefined antenna matchings, and this transmission of test packets (14') is stopped if the receiving concentrator radio module (18) signals a sufficiently high reception field strength to the smart meter (13), whereupon useful data packets (14) are transmitted in future with the currently set antenna matching of the predefined antenna matchings.

2. Method according to Claim 1, **characterized in that** the receiving concentrator radio module (18) transmits an indication of a currently sufficient reception field strength to the meter radio module (15) .

3. Method according to Claim 1 or 2, **characterized in that**, after the transmission of the test packets (14') has been stopped, the useful data packets (14) are transmitted in future with the currently set antenna matching which provides, in particular, the sufficiently high reception field strength at the receiving concentrator radio module (18).

4. Method according to one of the preceding claims, **characterized in that**, in a ping-pong mode, feedback from the receiving concentrator radio module (18) triggers the transmission with the next antenna matching from the sequence of different predefined antenna matchings in the meter radio module (15).

5. Method according to one of the preceding claims, **characterized in that** the test packets (14') and the useful data packets (14) are transmitted with the current antenna matching according to the currently set resonant inductance (23) or capacitance.

6. Method according to one of the preceding claims, **characterized in that** it is carried out in a time-controlled or periodically repeated manner, but is already initiated for the first time shortly after the start of operation.

7. Device for improving antenna matching in a smart meter (13) which is equipped with a bidirectional meter radio module (15) for a bidirectional close-range radio connection to at least one concentrator radio module (18) of a concentrator (17), wherein the meter radio module (15) is set up to emit from time to time a number of test packets (14') in succession and in the process to change over between different resonant inductances (23) or capacitances in order to set different predefined antenna matchings until the concentrator (17) reports to the smart meter (13) that a sufficiently high reception field strength has been reached in order to transmit from then on useful data packets (14) with the currently set antenna matching of the predefined antenna matchings.

8. Device according to the preceding claim, **characterized in that** an RSSI detector (25) is provided in the receiving concentrator radio module (18) .

## Revendications

1. Procédé permettant d'améliorer l'adaptation d'antenne dans un compteur électrique intelligent (13) dans le cas de liaisons radio bidirectionnelles de courte portée entre un module radio de compteur (15) du compteur électrique intelligent (13) et au moins un module radio de concentrateur (18) d'un concentrateur (17),
de temps à autre, une série de paquets de test (14') est transmise successivement par le module radio de compteur (15) à une fréquence d'émission prédéterminée lors d'adaptations d'antenne différentes et prédéterminées, et cette transmission de paquets de test (14') est interrompue lorsqu'une intensité de champ de réception suffisamment élevée est signalée au compteur électrique intelligent (13) par le module radio de concentrateur récepteur (18), les paquets de données utiles (14) étant alors transmis à partir de cet instant avec les adaptations d'antenne prédéterminées actuellement réglées.

2. Procédé selon la revendication 1, **caractérisé en ce qu'**une indication concernant une intensité de champ de réception actuellement suffisante est transmise au module radio de compteur (15) par le module radio de concentrateur récepteur (18).

3. Procédé selon la revendication 1 ou 2, **caractérisé en ce que**, après l'arrêt de la transmission des paquets de test (14'), la transmission des paquets de données utiles (14) sera effectuée avec une adaptation d'antenne actuellement réglée, qui ne délivrera au module radio de concentrateur récepteur (18) que l'intensité de champ de réception suffisamment élevée.

4. Procédé selon l'une des revendications précédentes, **caractérisé en ce que**, par un fonctionnement de type ping-pong, la transmission est déclenchée dans le module radio de compteur (15) par une rétroaction du module radio de concentrateur récepteur (18), avec l'adaptation d'antenne suivante parmi la séquence d'adaptations d'antenne prédéfinies différentes.

5. Procédé selon l'une des revendications précédentes, **caractérisé en ce que** les paquets de test (14') et les paquets de données utiles (14) sont transmis avec l'adaptation d'antenne actuelle conformément à l'inductance (23) ou à la capacité de résonance actuellement réglée.

6. Procédé selon l'une des revendications précédentes, **caractérisé en ce qu'**il est exécuté de manière temporisée ou répétée périodiquement, mais **en ce qu'**il est déclenché pour la première fois peu après le début du fonctionnement.

7. Dispositif permettant d'améliorer l'adaptation d'antenne dans un compteur électrique intelligent (13) équipé d'un module radio de compteur bidirectionnel (15) pour une communication radio bidirectionnelle à courte portée vers au moins un module radio de concentrateur (18) d'un concentrateur (17), dans lequel le module radio de compteur (15) est conçu pour transmettre successivement de temps à autre une série de paquets de test (14') et pour ainsi régler des adaptations d'antennes prédéterminées différentes afin de basculer entre différentes inductances (23) ou capacités de résonance, jusqu'à ce que le fait qu'une intensité de champ de réception suffisamment élevée est atteinte soit signalé en rétroaction par le concentrateur (17) au compteur électrique intelligent (13), afin de transmettre à partir de cet instant des paquets de données utiles (14) avec celles qui sont actuellement réglées des adaptations d'antenne prédéterminées.

8. Dispositif selon la revendication précédente, **caractérisé en ce qu'**il est prévu un détecteur RSSI (25) dans le module radio de concentrateur récepteur (18).
